# FASCICULE DE BREVET EUROPEEN

(11) **EP 1 966 821 B1**
(45) Date de publication et mention de la délivrance du brevet: **28.06.2017**
(21) Numéro de dépôt: 06841622.1
(22) Date de dépôt: 26.12.2006
(51) Int. Cl.: H01L 21/68, H01L 21/683, H01L 21/762

(54) **PROCEDE DE RELAXATION D'UNE COUCHE MINCE CONTRAINTE**
VERFAHREN ZUM RELAXIEREN EINES VERSPANNTEN DÜNNFILMS
METHOD FOR RELAXING A STRESSED THIN FILM

(30) Priorité: 27.12.2005 FR 0554110
(43) Date de publication de la demande: 10.09.2008
(73) Titulaire: Commissariat à l'Énergie Atomique et aux Énergies Alternatives, 75015 Paris (FR)
(72) Inventeur: DI CIOCCIO, Léa, F-38330 Saint Ismier (FR); BORDEL, Damien, F-38000 Grenoble (FR); GRENET, Geneviève, F-69006 Lyon (FR); REGRENY, Philippe, F-69380 Chasselay (FR)
(74) Mandataire: Ilgart, Jean-Christophe
(86) Numéro de dépôt international: PCT/EP2006/070211
(87) Numéro de publication internationale: WO 2007/074153

(56) Documents cités:
- EP-A- 1 014 452
- EP-A- 1 041 624
- WO-A-03/081664
- US-A1- 2004 239 827
- US-A1- 2005 016 217
- US-B1- 6 214 733
- KOSTRZEWA M ET AL: "Feasibility of strain relaxed InAsP and InGaAs compliant substrates" 2003 INTERNATIONAL CONFERENCE INDIUM PHOSPHIDE AND RELATED MATERIALS. CONFERENCE PROCEEDINGS. (IPRM). SANTA BARBARA, CA, MAY 12 - 16, 2003, INTERNATIONAL CONFERENCE ON INDIUM PHOSPHIDE AND RELATED MATERIALS, NEW YORK, NY : IEEE, US, 12 mai 2003 (2003-05-12), pages 437-440, XP010746758 ISBN: 0-7803-7704-4 cité dans la demande

## Description

### DOMAINE TECHNIQUE

L'invention concerne un procédé de relaxation d'une couche mince contrainte. Elle concerne en particulier le domaine des semi-conducteurs et notamment les couches minces obtenues par épitaxie.

### ÉTAT DE LA TECHNIQUE ANTÉRIEURE

Les composants microélectroniques et optoélectroniques sont maintenant réalisés à partir de combinaisons de matériaux monocristallins élaborés par des techniques d'épitaxie. Les techniques d'épitaxie modernes permettent de préparer et de combiner des matériaux de très grande pureté présentant des propriétés proches de leurs performances théoriques idéales.

Le document US6214733 B1 divulgue un procédé de transfert d'une couche mince contrainte utilisant une couche de polymère. Toutefois, un certain nombre de verrous technologiques subsistent entravant le plein développement de ces techniques. En effet, dans le cas des applications à l'optoélectronique, les alliages semi-conducteurs couvrent un très large domaine de composition et donc de longueurs d'ondes associées et d'applications. Cependant, le caractère monocristallin des substrats et l'utilisation des techniques d'épitaxie conduisent à des limitations intrinsèques contraignantes puisqu'il ne sera possible à priori de ne combiner que des matériaux présentant des paramètres de maille identiques ou très voisins. En fait, en fonction des substrats disponibles, seuls d'étroits domaines de composition peuvent être exploités.

La solution souvent adoptée pour contourner ce problème a été de faire croître par hétéroépitaxie des alliages présentant un désaccord de maille sur un substrat standard. Ces alliages sont alors contraints. Au delà d'une épaisseur dite critique (de quelque nm), l'énergie de contrainte provoque la relaxation plastique de la couche épitaxiée. Il en résulte l'apparition de défauts structuraux étendus (faible désaccord) ou une croissance par îlots (fort désaccord). Ce mode de relaxation conduit à une rugosification de la surface et donc à une détérioration des propriétés optiques et électroniques des matériaux.

Face à cette situation, le concept de « substrat compilant » a été proposé par Y.H.LO en 1991 pour permettre de réaliser des couches désaccordées en paramètre de maille. Il s'agit d'un substrat qui va s'adapter au paramètre de maille de la couche que l'on épitaxie sur celui-ci pour éviter une génération de défauts dans cette couche liés à la relaxation des contraintes de désaccord. On peut se référer à ce sujet à l'article « New approach to grow pseudomorphic structures over the criticual thickness » de Y.H. LO, Appl. Phys. Lett. 59 (18), pages 2311 à 2313, 28 octobre 1991.

L'approche originale consiste a considérer un fin substrat, d'épaisseur inférieure à l'épaisseur critique afin d'éviter la relaxation plastique. Ce substrat se déforme élastiquement (sans défauts cristallins) lors de la croissance en répartissant l'énergie élastique entre le substrat et la couche épitaxiale, afin d'adapter progressivement son paramètre de maille à celui de la couche en croissance Il résulte de ce concept que le substrat doit être libre de se déformer

Une approche voisine consiste à épitaxier une couche contrainte sur un substrat puis à relaxer cette couche pour permettre une reprise d'épitaxie sans génération de défauts structuraux. La relaxation a lieu avant la reprise d'épitaxie. Cette relaxation peut être obtenue par différents procédés comme la sous-gravure (voir l'article « High-quality fully relaxed In0.65Ga0.35As layers grown on InP using the paramorphic approach » de J.F. DAMLENCOURT et al., Appl. Phys. Lett. 75 (23), pages 3638 à 3640, 8 décembre 1999) ou un collage sur une couche visqueuse (voir l'article « Strain relaxation of SiGe islands on compliant oxide » de H. YIN et al., J. Appl. Phys., Vol.91, No. 12, pages 9716 à 9722, 15 juin 2002).

Cette dernière approche est la plus prometteuse. L'article cité de YIN et al. divulgue son application par l'utilisation d'un verre de borophosphosilicate (BPSG). L'article « Feasibility of III-V on-silicon strain relaxed substrates » de M. KOSTRZEWA et al., Journal of Crystal Growth 275 (2005), pages 157 à 166 divulgue son application par l'utilisation d'une cire. La couche contrainte une fois libérée du substrat initial sur lequel elle a été épitaxiée, se relaxe grâce à la viscosité d'un substrat support sur lequel elle a été transférée et après que le substrat initial ait été éliminé. Cette relaxation a lieu par formation d'ondulations en surface. Or, la relaxation par ondulations peut présenter des inconvénients majeurs. En fonction de leur amplitude et de leur longueur d'onde, elle peut conduire à une rugosification de surface de la couche épitaxiale en raison du champ de déformation non homogène qu'elle génère en surface du matériau. Il est donc nécessaire de développer une technique pour supprimer ces ondulations.

### EXPOSÉ DE L'INVENTION

La présente invention a été conçue dans le but de supprimer les ondulations provoquées lors de la relaxation d'une couche mince contrainte.

Elle consiste en un procédé de relaxation d'une couche mince contrainte, solidaire par une première face principale d'un support initial, la deuxième face principale de la couche mince étant dite face de contact, le procédé comprenant les étapes successives suivante :
- fourniture d'un support intermédiaire comprenant une couche de polymère présentant une face principale libre dite face de contact, le coefficient de dilatation thermique du polymère étant supérieur à celui de la couche mince,
- mise en contact adhérent de la face de contact de la couche mince contrainte avec la face de contact de la couche de polymère,
- élimination du support initial, provoquant ainsi la relaxation de la couche mince par formation d'ondulations et révélant la première face principale de la couche mince,
- augmentation de la température de la couche de polymère afin d'étirer la couche mince relaxée et de supprimer les ondulations,
- solidarisation de la première face principale de la couche mince avec une face d'un substrat de réception,
- élimination du support intermédiaire pour obtenir une couche mince relaxée solidaire du substrat de réception.

Selon un mode préféré de réalisation, l'étape de fourniture d'un support intermédiaire comprend le dépôt d'une couche dudit polymère à l'état liquide sur un substrat, puis sa polymérisation. Le dépôt de la couche de polymère peut se faire sur une face du substrat recouverte d'un film superficiel de résine. Le polymère à l'état liquide peut être déposé sur une face du substrat comportant des cales de positionnement de la couche dudit polymère. Les cales de positionnement peuvent être réalisées dans le même polymère que celui de la couche de polymère.

Avantageusement, la couche de polymère à l'état liquide déposée sur ledit substrat est planarisée par mise en contact de la face libre de la couche de polymère à l'état liquide avec une face d'un substrat de planarisation. La face du substrat de planarisation peut comprendre un film de résine. Le substrat de planarisation peut être éliminé après la polymérisation. L'élimination du substrat de planarisation peut être réalisée par séparation au moyen d'une lame insérée entre la couche de polymère et le substrat de planarisation.

Selon un mode de réalisation, la face de contact de la couche mince contrainte et la face de contact de la couche de polymère sont mises en contact adhérent par polymérisation d'un film de polymère interposé entre les faces de contact ou par collage moléculaire.

Le support initial peut être éliminé chimiquement ou mécaniquement.

Selon un mode particulier de réalisation, la solidarisation de la première face principale de la couche mince avec une face d'un substrat de réception est réalisée par collage moléculaire.

L'élimination du support intermédiaire peut se faire en éliminant d'abord le substrat du support intermédiaire, puis en éliminant la couche de polymère. Le substrat du support intermédiaire peut être éliminé par séparation au moyen d'une lame insérée entre lui-même et la couche de polymère. La couche de polymère peut être éliminée mécaniquement ou chimiquement.

La couche mince contrainte peut être une couche en un premier matériau semi-conducteur obtenue par hétéro-épitaxie sur un support initial en un deuxième matériau semi-conducteur.

### BRÈVE DESCRIPTION DES DESSINS

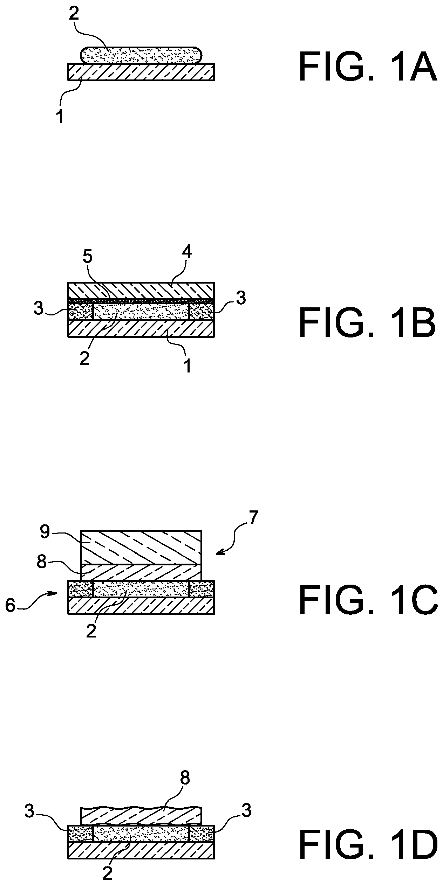

L'invention sera mieux comprise et d'autres avantages et particularités apparaîtront à la lecture de la description qui va suivre, donnée à titre d'exemple non limitatif, accompagnée des dessins annexés constitués par les figures 1A à 1G qui sont des vues en coupe transversale illustrant un exemple de mise en oeuvre du procédé selon l'invention.

### EXPOSÉ DÉTAILLÉ DE MODES DE RÉALISATION PARTICULIERS

Dans l'exemple de réalisation qui va maintenant être décrit, le polymère utilisé est du polydiméthylsiloxane ou PDMS. Cependant, tout autre polymère possédant des propriétés similaires peut être utilisé. Les propriétés requises sont une souplesse suffisante pour obtenir la relaxation de la couche contrainte, même pour une couche de polymère de forte épaisseur, et un coefficient de dilatation thermique suffisamment supérieur à celui du matériau constituant la couche contrainte. La couche de polymère permet ainsi d'absorber les contraintes de relaxation de la couche contrainte qui lui sera solidarisée.

La figure 1A représente un premier substrat 1, par exemple en silicium, sur lequel on a déposé une couche de PDMS 2 à l'état liquide. En variante, on peut prévoir de recouvrir le premier substrat d'une couche de résine pour faciliter le retrait ultérieur du premier substrat. Le polymère étant un matériau visqueux à l'état liquide, l'étalement se fait spontanément. Le polymère peut également être déposé en plusieurs fois à l'aide d'une tournette.

Afin d'obtenir une bonne homogénéité de la couche de polymère, il est préférable, préalablement à son dépôt, de positionner des cales sur la surface du substrat 1 afin de mieux maîtriser l'épaisseur du polymère déposé. Ces cales, par exemple des plots régulièrement répartis à la surface du substrat 1, sont représentées sur la figure 1B sous la référence 3. Elles peuvent être en tout matériau approprié. Cependant, l'utilisation de cales en PDMS, déjà polymérisé, permet de les englober dans la couche de polymère 2.

Un deuxième substrat, par exemple en silicium, présentant une face de très bonne planéité est ensuite utilisé. Une fine couche (ou film) de résine 5 peut être déposée sur la face de très bonne planéité du deuxième substrat. Le deuxième substrat, référencé 4 sur la figure 1B, est ensuite déposé sur les cales 3 afin d'homogénéiser en épaisseur la couche de polymère 2, la couche de résine 5 se trouvant en contact avec la couche de polymère 2. La couche de résine 5 sert à faciliter l'enlèvement du substrat 4 une fois que l'on aura, dans une étape ultérieure, polymérisé la couche de PDMS 2.

Ensuite, on procède à la polymérisaton du polymère de la couche 2 au moyen d'un recuit. La polymérisation a lieu à l'aide d'un précurseur mélangé au polymère. Elle peut se faire à différentes températures, par exemple à température ambiante pendant 48 heures ou à 150°C pendant 10 minutes.

Le substrat 4 est ensuite retiré, par exemple en insérant une lame entre le substrat 4 et la couche 2 polymérisée. La couche de résine 5 facilite le décollement du substrat 4. On obtient ainsi une structure, dite support intermédiaire, comprenant le substrat 1 supportant la couche de polymère 2. Il est possible en variante de retirer également le substrat 1, par exemple en insérant une lame entre le substrat 1 et la couche 2 polymérisée. Le PDMS assure alors à lui seul la tenue mécanique nécessaire pour la suite du procédé. Ceci est possible si cette couche de PDMS est suffisamment épaisse (de l'ordre du mm).

Le support intermédiaire, référencé 6 (voir la figure 1C), reçoit alors une structure 7 comprenant une fine couche contrainte 8 épitaxiée sur un troisième substrat 9 (semi-conducteur III-V ou autre), la couche contrainte 8 étant en regard de la couche de polymère 2. La structure 7 est rendue solidaire du support intermédiaire 6. La solidarisation peut être obtenue par polymérisation d'un film de polymère préalablement déposée sur la couche contrainte. Elle peut aussi être obtenue par collage moléculaire.

Le substrat 9 est ensuite éliminé. L'élimination peut être obtenue chimiquement (par gravure sélective sèche ou humide) ou mécaniquement. Des couches d'arrêt peuvent avantageusement avoir été prévues entre le substrat 9 et la couche contrainte 8 pour faciliter l'élimination du substrat 9. La couche contrainte 8 se relaxe alors sur la couche de polymère 2 et sur les cales 3 dans l'exemple représenté. Cette relaxation s'effectue par formation d'ondulations (voir la figure 1D). On peut se référer à ce propos à l'article de S. PERICHON LACOUR et al., intitulé « Stretchable gold conductors on elastomeric substrates », Appl. Phys. Lett., Vol. 82, No. 15, 14 avril 2003, pages 2404 à 2406.

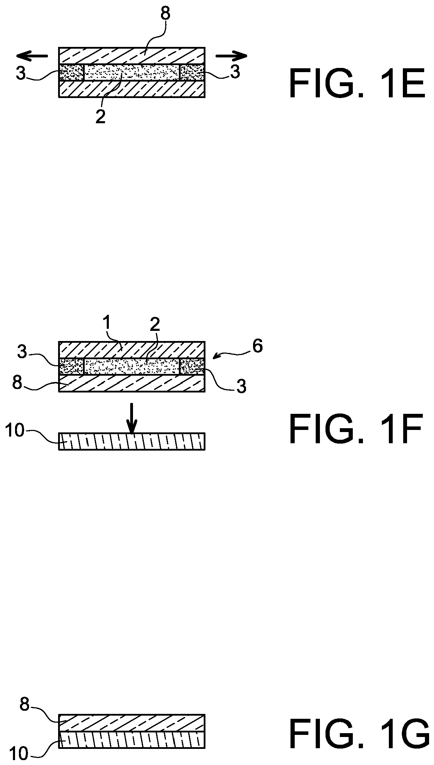

L'étape suivante du procédé selon l'invention est basée sur le fait que le coefficient de dilatation du polymère est suffisamment supérieur à celui de la couche contrainte. Le polymère est monté en température, par exemple en plaçant l'ensemble illustré par la figure 1D sur une plaque chauffante à une température adéquate pour que la dilatation du PDMS entraîne la couche contrainte ondulée 8. Celui-ci se tend alors en supprimant ainsi les ondulations (voir la figure 1E).

Un quatrième substrat 10, de type standard (en silicium par exemple ou en silicium oxydé en surface), est collé sur la couche 8 maintenant étirée. Le collage peut être un collage moléculaire (voir la figure 1F). La température est avantageusement maintenue pendant ce collage afin d'éviter le retour des ondulations en cas de refroidissement. Le collage du substrat 10 sur la couche 8 permet de maintenir la couche 8 étirée lors du refroidissement.

Le support intermédiaire 6 est retiré. Pour obtenir ce résultat, on peut retirer d'abord le substrat 1 s'il est encore présent, par exemple par insertion d'une lame entre le substrat 1 et le polymère formant la couche 2 et les cales 3. Le polymère peut ensuite être éliminé mécaniquement ou chimiquement, par gravure sélective sèche ou humide. On obtient une couche 8 relaxée, sans ondulation, prête à une reprise d'épitaxie et reportée sur un substrat standard 10 (voir la figure 1G).

La couche de PDMS peut avoir une épaisseur de l'ordre du millimètre (typiquement 2 mm). La couche contrainte 8 peut être constituée d'InGaAs contraint à 0,8% en compression sur un substrat 9 en InP. Cette couche contrainte peut avoir été obtenue par épitaxie par jet moléculaire d'une couche de 30 nm d'épaisseur d'In_{0,65}Ga_{0,35}As sur un substrat d'InP. L'épaisseur d'InGaAs doit rester inférieure à l'épaisseur critique, épaisseur à partir de laquelle la couche d'InGaAs se relaxe (en formant des dislocations ...). Avantageusement, on prévoira entre la couche d'InGaAs contrainte et le substrat d'InP des couches d'arrêt conservant le paramètre de maille de l'InP par exemple, en empilement sur l'InP, une couche d' In_{0,53}Ga_{0,47}As et une couche d'InP (chaque couche d'arrêt ayant typiquement une épaisseur de l'ordre de 200 nm). L'épaisseur de la couche 8 peut être de l'ordre de la centaine de A, par exemple 30 nm pour obtenir une contrainte de 0,8% en compression. L'épaisseur dépend de la contrainte. La couche 8 peut être collée sur le support intermédiaire 6, par exemple la couche de PDMS (2 mm) obtenue après retrait des substrats 1 et 4, à l'aide d'une fine couche de PDMS de quelques dizaines de µm d'épaisseur (par exemple 40 µm), déposée à la tournette sur la couche contrainte. Cette pellicule de collage peut également être polymérisée à température ambiante pendant 48 heures. Afin d'obtenir la relaxation, le substrat 9 en InP peut être gravé chimiquement de façon sélective à l'aide d'une solution d'HCl si les couches d'arrêt d'InGaAs et d'InP ont été utilisées. On grave sélectivement le substrat d'InP dans une solution de HCl:H₂O (3 :1), puis la couche d'InGaAs dans une solution de H₂SO₄:H₂O₂:H₂O (1:1:10), puis la couche d'arrêt d'InP avec la même solution que celle utilisée pour graver le substrat d'InP.

Dans le cas d'une couche de InGaAs contrainte en compression à 0,8%, la température nécessaire à la dilatation du polymère pour obtenir une couche sans ondulation est d'environ 150°C. Le PDMS peut être chauffé par exemple à l'aide d'une platine chauffante. La couche d'InGaAs 8, une fois les ondulations éliminées, peut être reportée sur un substrat hôte par exemple par collage moléculaire. Les forces de collage entre la couche d'InGaAs 8 relaxée et le substrat hôte étant plus fortes que celles entre le polymère et la couche relaxée 8, le PDMS adhérant à la couche 8 pouvant être retiré par simple pelage.

## Revendications

1. Procédé de relaxation d'une couche mince contrainte (8), solidaire par une première face principale d'un support initial (9), la deuxième face principale de la couche mince (8) étant dite face de contact, le procédé comprenant les étapes successives suivante :
- fourniture d'un support intermédiaire (6) comprenant une couche de polymère (2) présentant une face principale libre dite face de contact, le coefficient de dilatation thermique du polymère étant supérieur à celui de la couche mince (8),
- mise en contact adhérent de la face de contact de la couche mince contrainte (8) avec la face de contact de la couche de polymère (2),
- élimination du support initial (9), provoquant ainsi la relaxation de la couche mince (8) par formation d'ondulations et révélant la première face principale de la couche mince,
- augmentation de la température de la couche de polymère (2) afin d'étirer la couche mince relaxée (8) et de supprimer les ondulations,
- solidarisation de la première face principale de la couche mince (8) avec une face d'un substrat de réception (10),
- élimination du support intermédiaire (6) pour obtenir une couche mince (8) relaxée solidaire du substrat de réception (10).

2. Procédé selon la revendication 1, **caractérisé en ce que** l'étape de fourniture d'un support intermédiaire comprend le dépôt d'une couche dudit polymère à l'état liquide sur un substrat (1), puis sa polymérisation.

3. Procédé selon la revendication 2, **caractérisé en ce que** le dépôt de la couche dudit polymère se fait sur une face du substrat (1) recouverte d'un film superficiel de résine.

4. Procédé selon l'une des revendications 2 ou 3, **caractérisé en ce que** ledit polymère à l'état liquide est déposé sur une face du substrat comportant des cales de positionnement (3) de la couche dudit polymère.

5. Procédé selon la revendication 4, **caractérisé en ce que** les cales de positionnement (3) sont réalisées dans le même polymère que celui de la couche de polymère (2).

6. Procédé selon l'une quelconque des revendications 2 à 5, **caractérisé en ce que** la couche de polymère (2) à l'état liquide déposée sur ledit substrat (1) est planarisée par mise en contact de la face libre de la couche de polymère à l'état liquide avec une face d'un substrat de planarisation (4).

7. Procédé selon la revendication 6, **caractérisé en ce que** ladite face du substrat de planarisation (4) comprend un film de résine (5).

8. Procédé selon l'une des revendications 6 ou 7, **caractérisé en ce que** le substrat de planarisation (4) est éliminé après ladite polymérisation.

9. Procédé selon la revendication 8, **caractérisé en ce que** l'élimination du substrat de planarisation (4) est réalisée par séparation au moyen d'une lame insérée entre la couche de polymère (2) et le substrat de planarisation (4).

10. Procédé selon l'une quelconque des revendications 2 à 9, **caractérisé en ce que** le substrat (1) est éliminé après polymérisation.

11. Procédé selon l'une quelconque des revendications 1 à 10, **caractérisé en ce que** le polymère de ladite couche de polymère (2) est du polydiméthylsiloxane (PDMS).

12. Procédé selon l'une quelconque des revendications 1 à 11, **caractérisé en ce que** la face de contact de la couche mince contrainte (8) et la face de contact de la couche de polymère (2) sont mises en contact adhérent par polymérisation d'un film de polymère interposé entre les faces de contact ou par collage moléculaire.

13. Procédé selon l'une quelconque des revendications 1 à 12, **caractérisé en ce que** le support initial (9) est éliminé chimiquement ou mécaniquement.

14. Procédé selon l'une quelconque des revendications 1 à 13, **caractérisé en ce que** la solidarisation de la première face principale de la couche mince (8) avec une face d'un substrat de réception (10) est réalisée par collage moléculaire.

15. Procédé selon l'une quelconque des revendications 1 à 14, **caractérisé en ce que** l'élimination du support intermédiaire (6) se fait en éliminant d'abord le substrat (1) du support intermédiaire, puis en éliminant la couche de polymère (2).

16. Procédé selon la revendication 15, **caractérisé en ce que** le substrat (1) du support intermédiaire est éliminé par séparation au moyen d'une lame insérée entre lui-même et la couche de polymère (2).

17. Procédé selon la revendication 15, **caractérisé en ce que** la couche de polymère (2) est éliminée mécaniquement ou chimiquement.

18. Procédé selon l'une quelconque des revendications 1 à 17, **caractérisé en ce que** la couche mince contrainte (8) est une couche en un premier matériau semi-conducteur obtenue par hétéro-épitaxie sur un support initial (9) en un deuxième matériau semi-conducteur.

## Patentansprüche

1. Verfahren zum Relaxieren einer verspannten Dünnschicht (8), die mit einer ersten Hauptfläche fest mit einem ursprünglichen Träger (9) verbunden ist, wobei die zweite Hauptfläche der Dünnschicht (8) die sogenannte Kontaktfläche ist, wobei das Verfahren die aufeinanderfolgenden, nachstehenden Schritte umfasst:
- Bereitstellen eines Zwischenträgers (6) mit einer Polymerschicht (2), die eine freie Hauptfläche, Kontaktfläche genannt, aufweist, wobei der Wärmeausdehnungskoeffizient des Polymers höher als der der Dünnschicht (8) ist,
- haftendes Inkontaktbringen der Kontaktfläche der verspannten Dünnschicht (8) mit der Kontaktfläche der Polymerschicht (2),
- Entfernen des ursprünglichen Trägers (9), wodurch das Relaxieren der Dünnschicht (8) durch Wellenbildung hervorgerufen wird und die erste Hauptfläche der Dünnschicht freigegeben wird,
- Erhöhen der Temperatur der Polymerschicht (2), um die relaxierte Dünnschicht (8) zu strecken und die Wellen zu beseitigen,
- Verbinden der ersten Hauptfläche der Dünnschicht (8) mit einer Seite eines Aufnahmesubstrats (10),
- Entfernen des Zwischenträgers (6), um eine fest mit dem Aufnahmesubstrat (10) verbundene, relaxierte Dünnschicht (8) zu erhalten.

2. Verfahren nach Anspruch 1, **dadurch gekennzeichnet, dass** der Schritt des Bereitstellens eines Zwischenträgers das Aufbringen einer Schicht des Polymers im flüssigen Zustand auf ein Substrat (1), dann dessen Polymerisation, umfasst.

3. Verfahren nach Anspruch 2, **dadurch gekennzeichnet, dass** das Aufbringen der Polymerschicht auf eine Fläche des Substrats (1) erfolgt, die mit einem Oberflächenharzfilm überdeckt ist.

4. Verfahren nach einem der Ansprüche 2 oder 3, **dadurch gekennzeichnet, dass** das Polymer im flüssigen Zustand auf eine Fläche des Substrats aufgetragen wird, die Positionierkeile (3) zum Positionieren der Polymerschicht hat.

5. Verfahren nach Anspruch 4, **dadurch gekennzeichnet, dass** die Positionierkeile (3) aus dem gleichen Polymer ausgebildet sind wie die Polymerschicht (2).

6. Verfahren nach einem der Ansprüche 2 bis 5, **dadurch gekennzeichnet, dass** die im flüssigen Zustand auf das Substrat (1) aufgebrachte Polymerschicht (2) durch Inkontaktbringen der freien Fläche der Polymerschicht im flüssigen Zustand mit einer Fläche eines Planarisierungssubstrats (4) planarisiert wird.

7. Verfahren nach Anspruch 6, **dadurch gekennzeichnet, dass** die Fläche des Planarisierungssubstrats (4) einen Harzfilm (5) aufweist.

8. Verfahren nach einem der Ansprüche 6 oder 7, **dadurch gekennzeichnet, dass** das Planarisierungssubstrats (4) nach der Polymerisation entfernt wird.

9. Verfahren nach Anspruch 8, **dadurch gekennzeichnet, dass** das Entfernen des Planarisierungssubstrats (4) durch Trennen mittels einer Klinge erfolgt, die zwischen Polymerschicht (2) und Planarisierungssubstrat (4) eingeschoben wird.

10. Verfahren nach einem der Ansprüche 2 bis 9, **dadurch gekennzeichnet, dass** das Substrat (1) nach der Polymerisation entfernt wird.

11. Verfahren nach einem der Ansprüche 1 bis 10, **dadurch gekennzeichnet, dass** das Polymer der Polymerschicht (2) Polydimethylsiloxan (PDMS) ist.

12. Verfahren nach einem der Ansprüche 1 bis 11, **dadurch gekennzeichnet, dass** die Kontaktfläche der verspannten Dünnschicht (8) und die Kontaktfläche der Polymerschicht (2) durch Polymerisation eines Polymerfilms, der zwischen die Kontaktflächen eingefügt wird, oder durch modekulares Kleben haftend in Kontakt gebracht werden.

13. Verfahren nach einem der Ansprüche 1 bis 12, **dadurch gekennzeichnet, dass** der ursprüngliche Träger (9) chemisch oder mechanisch entfernt wird.

14. Verfahren nach einem der Ansprüche 1 bis 13, **dadurch gekennzeichnet, dass** die feste Verbindung der ersten Hauptfläche der Dünnschicht (8) mit einer Fläche eines Aufnahmesubstrats (10) durch molekulares Kleben erfolgt.

15. Verfahren nach einem der Ansprüche 1 bis 14, **dadurch gekennzeichnet, dass** das Entfernen des Zwischenträgers (6) dadurch erfolgt, dass zunächst das Substrat (1) des Zwischenträgers entfernt wird und dann die Polymerschicht (2) entfernt wird.

16. Verfahren nach Anspruch 15, **dadurch gekennzeichnet, dass** das Substrat (1) des Zwischenträgers durch Trennen mittels einer Klinge entfernt wird, die zwischen diesem und der Polymerschicht (2) eingeschoben wird.

17. Verfahren nach Anspruch 15, **dadurch gekennzeichnet, dass** die Polymerschicht (2) mechanisch oder chemisch entfernt wird.

18. Verfahren nach einem der Ansprüche 1 bis 17, **dadurch gekennzeichnet, dass** die verspannte Dünnschicht (8) eine Schicht aus einem ersten Halbleitermaterial ist, die durch Heteroepitaxie auf einem ursprünglichen Träger (9) aus einem zweiten Halbleitermaterial gewonnen wird.

## Claims

1. Method for relaxing a strained thin film (8), secured via a first main face to an initial support (9), the second main face of the thin film (8) being called as contact face, the method comprising the following successive steps:
- supplying an intermediate support (6) comprising a polymer layer (2) having a main free face called as contact face, the thermal expansion coefficient of the polymer bieng greater than that of the thin film (8),
- adhesively bringing into contact the contact face of the strained thin film (8) with the contact face of the polymer layer (2),
- eliminating the initial support (9), thereby provoking the relaxation of the thin film (8) through formation of wrinkles and revealing the first main face of the thin film,
- increasing the temperature of the polymer layer (2) in order to stretch the relaxed thin film (8) and to eliminate the wrinkles,
- securing the first main face of the thin film (8) with one face of a receiving substrate (10),
- eliminating the intermediate support (6) to obtain a relaxed thin film (8) integral with the receiving substrate (10).

2. Method according to claim 1, **characterized in that** the step of supplying an intermediate support comprises the deposition of a layer of said polymer in the liquid state on a substrate (1), then its polymerisation.

3. Method according to claim 2, **characterized in that** the deposition of the layer of said polymer takes place on one face of the substrate (1) covered with a superficial film of resin.

4. Method according to one of claims 2 or 3, **characterized in that** said polymer in the liquid state is deposited on one face of the substrate comprising positioning spacers (3) for the layer of said polymer.

5. Method according to claim 4, **characterized in that** the positioning spacers (3) are formed in the same polymer as that of the polymer layer (2).

6. Method according to any one of claims 2 to 5, **characterized in that** the polymer layer (2) in the liquid state deposited on said substrate (1) is planarised by bringing into contact the free face of the polymer layer in the liquid state with a face of a planarisation substrate (4).

7. Method according to claim 6, **characterized in that** said face of the planarisation substrate (4) comprises a film of resin (5).

8. Method according to one of claims 6 or 7, **characterized in that** the planarisation substrate (4) is eliminated after said polymerisation.

9. Method according to claim 8, **characterized in that** the elimination of the planarisation substrate (4) is carried out by separation by means of a blade inserted between the polymer layer (2) and the planarisation substrate (4).

10. Method according to any one of claims 2 to 9, **characterized in that** the substrate (1) is eliminated after polymerisation.

11. Method according to any one of claims 1 to 10, **characterized in that** the polymer of said polymer layer (2) is polydimethylsiloxane (PDMS).

12. Method according to any one of claims 1 to 11, **characterized in that** the contact face of the strained thin film (8) and the contact face of the polymer layer (2) are brought into adhesive contact by polymerisation of a film of polymer interposed between the contact faces or by molecular bonding.

13. Method according to any one of claims 1 to 12, **characterized in that** the initial support (9) is eliminated chemically or mechanically.

14. Method according to any one of claims 1 to 13, **characterized in that** the securing of the first main face of the thin film (8) with one face of a receiving substrate (10) is carried out by molecular bonding.

15. Method according to any one of claims 1 to 14, **characterized in that** the elimination of the intermediate support (6) is carried out by eliminating firstly the substrate (1) of the intermediate support, then by eliminating the polymer layer (2).

16. Method according to claim 15, **characterized in that** the substrate (1) of the intermediate support is eliminated by separation by means of a blade inserted between itself and the polymer layer (2).

17. Method according to claim 15, **characterized in that** the polymer layer (2) is eliminated mechanically or chemically.

18. Method according to any one of claims 1 to 17, **characterized in that** the strained thin film (8) is a layer in a first semi-conductor material obtained by hetero-epitaxy on an initial support (9) in a second semi-conductor material.
